# EUROPÄISCHE PATENTSCHRIFT

(11) **EP 0 586 735 B1**
(45) Veröffentlichungstag und Bekanntmachung des Hinweises auf die Patenterteilung: **22.05.1996**
(21) Anmeldenummer: 92115516.4
(22) Anmeldetag: 10.09.1992
(51) Int. Cl.: H01L 29/772

(54) **MOS-Transistor**
MOS transistor
Transistor MOS

(43) Veröffentlichungstag der Anmeldung: 16.03.1994
(73) Patentinhaber: SIEMENS AKTIENGESELLSCHAFT, D-80333 München (DE)
(72) Erfinder: Höltge, Harald, Dipl.-ing., W-8000 München 22 (DE)

(56) Entgegenhaltungen:
- EP-A- 0 309 748
- EP-A- 0 330 142
- DE-A- 2 855 844

## Beschreibung

Die Erfindung betrifft einen MOS-Transistor nach dem Oberbegriff des Patentanspruchs 1.

MOS-Feldeffekttransistoren mit zwei Gate-Elektroden sind bekannt und werden auch als MOS-Tetroden bezeichnet. Derartige MOS-Tetroden zeichnen sich durch gute HF-Eigenschaften aus und werden beispielsweise in Vorstufen von Fernsehtunern verwendet, deren Spannungsversorgung fast ausschließlich bei ungefähr 12 Volt liegt.

MOS-Trioden sind aus EP-A-309 748 bekannt.

In Vorstufen von Fernsehtunern wird eine integrierte Drainstrom-Stabilisierung angestrebt. Der hierfür vorgesehene IC (Integrierte Schaltkreis), dessen Hauptbestandteil eine MOS-Tetrode ist, soll so ausgelegt werden, daß er bei den in herkömmlichen Tunern verfügbaren Spannungen arbeitet. Als Nebenbedingung wird z.B. verlangt, daß in Fernsehtunern Gate 2-Regelspannungen zur Verfügung stehen, die ungefähr von 1 Volt bis 8 Volt reichen. Voraussetzung für die Anwendung eines solchen Bauelementes ist daher eine relativ hohe Gate 2-Einsatzspannung. Für eine hohe Gate 2-Einsatzspannung muß die Dotierungskonzentration der beispielsweise p-leitenden Gate 2-Kanalzone höher sein als diejenige des Grundmaterials, beipielsweise des p-dotierten Siliziums. Dies erreicht man z.B. durch eine entsprechende Bor-Implantation.

An einem pn-Übergang mit relativ hohen p- und n-Konzentrationen, der nur durch eine dünne Gate-Oxidschicht isoliert unter einer Gate-Elektrode liegt, beispielsweise unter der zweiten, der Drain-Elektrode benachbarten Gate-Elektrode, kommt es bereits bei relativ niedrigen Drainspannungen zu einen Tunneldurchbruch. Beispielsweise könnte die beschriebene MOS-Tetrode bei einer Gate 2-Einsatzspannung von größer 1 Volt nur bei Drainspannungen bis zu 9 Volt arbeiten. Ein solches Bauelement soll aber bei Drainspannungen bis zu 13 Volt, wie sie beispielsweise für Fernsehtuner benötigt werden, einsetzbar sein.

Der Erfindung liegt daher die Aufgabe zugrunde, bei einem MOS-Transistor der eingangs genannten Art diese Nachteile zu vermeiden und einen MOS-Transistor zu schaffen, der unter Vermeidung von Tunneldurchbrüchen bei Drainspannungen bis zu 13 Volt einsetzbar ist, und zwar unter Beibehaltung dessen guter HF-Eigenschaften.

Diese Aufgabe wird erfindungsgemäß mit den Merkmalen des Anspruchs 1 gelöst.

Vorteilhafte Ausgestaltungen und Weiterbildungen der Erfindung sind Gegenstand zusätzlicher Ansprüche.

Die mit der Erfindung erzielten Vorteile bestehen insbesondere darin, daß durch das Zwischenfügen einer dritten Gate-Elektrode dafür gesorgt wird, daß die hochdotierte Zone der Drain-Elektrode nicht mit der hochdotierten Kanalzone unter der zweiten Gate-Elektrode in Berührung kommt. Damit wird eine Erhöhung der Tunnel-Durchbruchspannung erreicht, so daß auch bei relativ hohen Drainspannungen Tunnel-Durchbrüche vermieden sind. Von weiterem Vorteil ist, daß die vorgeschlagene MOS-Pentode genauso gute HF-Eigenschaften gewährleistet, wie sie die herkömmlichen MOS-Tetroden aufweisen.

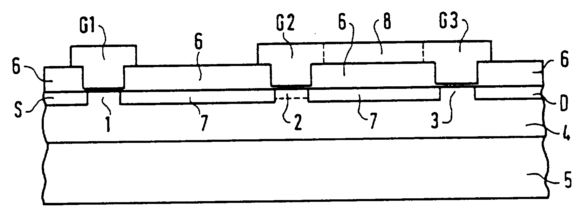

Anhand eines in der Figur der Zeichnung dargestellten Ausführungsbeispiels wird die Erfindung im folgenden näher erläutert.

Der in der FIG im Schnitt dargestellte MOS-Transistor besteht als einem Halbleitersubstrat 5, vorzugsweise aus Silizium. Auf das Siliziumsubstrat 5 wird als Grundmaterial 4 des aktiven Bereichs eine p-dotierte, vorzugsweise Bordotierte Siliziumschicht epitaktisch aufgebracht. Im Oberflächenbereich des Grundmaterials 4 sind die einzelnen Komponenten des MOS-Transistors angeordnet.

Die konventionellen Hauptprozesse zum Herstellen eines solchen MOS-Transistors mit Gate-Elektroden, die zweckmäßig aus Aluminium bestehen, sind im wesentlichen folgende: Ätzung der Gate-Fenster in ein phosphordotiertes Siliziumoxid 6. Gate-Oxidation unter den später aufgebrachten Gate-Elektroden G1, G2 und G3 mit gleichzeitiger Eindiffusion von Phosphor aus dem phosphordotiertem Siliziumoxid 6 zur Bildung von Source S, Drain D und den ebenso n-leitenden, hochdotierten n⁺-Zwischengebieten 7 zwischen Gate-Elektrode G1 und Gate-Elektrode G2 sowie zwischen Gate-Elektrode G2 und Gate-Elektrode G3. Danach erfolgt die Ätzung der nicht dargestellten Kontaktfenster für Source S und Drain D und schließlich die Al-Bedampfung und Strukturierung. Die zweite Kanalzone 2 unter der zweiten Gate-Elektrode G2 ist dabei höher p-dotiert als das Grundmaterial 4. In der FIG ist die stark p-dotierte Kanalzone 2 durch eine gestrichelte Linie angedeutet. Die höhere p-Dotierung des Grundmaterials in der zweiten Kanalzone 2 erreicht man zweckmaßig durch eine Bor-Implantation. Zwischen zweiter Gate-Elektrode G2 und Drain-Elektrode D ist eine dritte Gate-Elektrode G3 mit einer dritten Kanalzone 3 vorgesehen. Die Kanalzone 3 unter der dritten Gate-Elektrode G3 ist dabei niedriger dotiert als die hochdotierte Kanalzone 2 unter der zweiten Gate-Elektrode G2. Vorzugsweise weist die dritte Kanalzone 3 die gleiche Dotierungskonzentration wie das Grundmaterial 4 auf, das vorzugsweise aus p-dotiertem Silizium besteht. Die zweite Gate-Elektrode G2 und die dritte Gate-Elektrode G3 sind elektrisch leitend miteinander verbunden. Die Verbindung 8 erfolgt dabei zweckmäßig metallisch zwischen diesen beiden Gate-Elektroden und ist in der FIG durch gestrichelte Linien zwischen diesen beiden Elektroden G2 und G3 angedeutet.

Die Länge der zweiten Kanalzone 2 ist um die Länge der dritten Kanalzone 3 verkürzt. Die Längen der zweiten Kanalzone 2 und der dritten Kanalzone 3 sind vorzugsweise halb so groß wie die Länge der zweiten Kanalzone bei herkömmlichen Tetroden, um gleich gute HF-Eigenschaften zu gewährleisten.

Das Einfügen der dritten Gate-Elektrode G3 bietet den zusätzlichen Vorteil, daß eine deutlich kleinere Rückwirkungskapazität zwischen erster Gate-Elektrode G1 und Drain-Elektrode D als bei herkömmlichen MOS-Tetroden erreicht wird.

Wenn die erste Kanalzone 1 zusammen mit der zweiten Kanalzone 2 gleichermaßen stark Bor-dotiert wird wie die zweite Kanalzone 2, dann kann die Länge der ersten Kanalzone wesentlich kleiner (bis in den Submikron-Bereich hinein) dimensioniert werden. Diese Maßnahme führt zu einer erheblichen Verbesserung der HF-Eigenschaften des Bauelements.

## Patentansprüche

1. MOS-Transistor gebildet in einem Grundmaterial (4), mit einem Source-Gebiet, einem Drain-Gebiet , einer dazwischen angeordneten ersten Gate-Elektrode (G1) mit einer ersten Kanalzone (1), einer zweiten Gate-Elektrode (G2) mit einer zweiten Kanalzone (2), deren Dotierungskonzentration höher als die des Grundmaterials ist, **dadurch gekennzeichnet,** daß zwischen zweiter Gate-Elektrode (G2) und Drain-Gebiet eine dritte Gate-Elektrode (G3) mit einer dritten Kanalzone (3) vorgesehen ist, daß die dritte Kanalzone (3) niedriger dotiert ist als die hochdotierte zweite Kanalzone (2), daß die Kanalzonen (1, 2, 3) und das Grundmaterial (4) vom entgegengesetzten Leitungstyp wie das Source- und Drain-Gebiet sind, daß die zweite Gate-Elektrode (G2) mit der dritten Gate-Elektrode (G3) elektrisch leitend verbunden ist und daß zwischen den Gate-Elektroden hochdotierte Zwischengebiete (7) vom gleichen Leitungstyp wie das Source- und Drain-Gebiet ausgebildet sind.

2. MOS-Transistor nach Anspruch 1, **dadurch gekennzeichnet,** daß die dritte Kanalzone (3) die gleiche Dotierungskonzentration wie das Grundmaterial (4) aufweist.

3. MOS-Transistor nach Anspruch 1 oder 2, **dadurch gekennzeichnet,** daß das Grundmaterial (4) p-dotiertes Silizium ist.

4. MOS-Transistor nach einem der Ansprüche 1 bis 3, **dadurch gekennzeichnet,** daß bei einer gleich starken Dotierung von erster Kanalzone (1) und zweiter Kanalzone (2) die Länge der ersten Kanalzone (1) kleiner ausgelegt ist als die Länge von zweiter Kanalzone (2) und dritter Kanalzone (3).

## Claims

1. MOS transistor formed in a substrate material (4), having a source region, a drain region, a first gate electrode (G1) which is arranged in between and has a first channel zone (1), a second gate electrode (G2) having a second channel zone (2) whose doping concentration is greater than that of the substrate material, characterized in that a third gate electrode (G3) having a third channel zone (3) is provided between the second gate electrode (G2) and the drain region, in that the third channel zone (3) is more weakly doped than the highly-doped second channel zone (2), in that the channel zones (1, 2, 3) and the substrate material (4) are of the opposite conductance type to the source region and drain region, in that the second gate electrode (G2) is electrically conductively connected to the third gate electrode (G3), and in that highly-doped intermediate regions (7), of the same conductance type as the source region and drain region, are formed between the gate electrodes.

2. MOS transistor according to Claim 1, characterized in that the third channel zone (3) has the same doping concentration as the substrate material (4).

3. MOS transistor according to Claim 1 or 2, characterized in that the substrate material (4) is p-doped silicon.

4. MOS transistor according to one of Claims 1 to 3, characterized in that, with a doping of the first channel zone (1) and of the second channel zone (2) being of equal intensity, the length of the first channel zone (1) is designed to be less than the length of the second channel zone (2) and of the third channel zone (3).

## Revendications

1. Transistor MOS formé dans un matériau (4) de base et comportant une région de source, une région de drain, une première électrode (G1) de grille disposée entre ces régions et ayant une première zone (1) de canal, une seconde électrode (G2) de grille ayant une seconde zone (2) de canal, dont la concentration de dopant est plus grande que celle du matériau de base, caractérisé en ce qu'il est prévu entre la seconde électrode (G2) de grille et la région de drain une troisième électrode (G3) de grille ayant une troisième zone (3) de canal, la troisième zone (3) de canal est moins dopée que la seconde zone (2) de canal fortement dopée, les zones (1,2,3) de canal et le matériau (4) de base sont du type de conductivité opposé à celui des régions de source et de drain, la seconde électrode (G2) de grille est reliée à la troisième électrode (G3) de grille de manière à conduire l'électricité et des régions (7) intermédiaires fortement dopées du même type de conductivité que les régions de source et de drain sont formées entre les électrodes de grille.

2. Transistor MOS suivant la revendication 1, caractérisé en ce que la troisième zone (3) de canal a la même concentration de dopant que le matériau (4) de base.

3. Transistor MOS suivant la revendication 1 ou 2, caractérisé en ce que le matériau (4) de base est du silicium ayant un dopage de type p.

4. Transistor MOS suivant l'une des revendications 1 à 3, caractérisé en ce que si la première zone (1) de canal et la seconde zone (2) de canal sont autant dopées l'une que l'autre, la longueur de la première zone (1) de canal est plus petite que la longueur de la deuxième zone (2) de canal et de la troisième zone (3) de canal.
